# EUROPEAN PATENT APPLICATION

(11) **EP 2 315 363 A1**
(43) Date of publication of application: **27.04.2011**
(21) Application number: 09806672.3
(22) Date of filing: 06.08.2009
(51) Int. Cl.: H04B 1/26, H03L 7/093, H03L 7/099, H04B 1/10, H04N 5/44

(54) **RECEPTION DEVICE, RECEPTION METHOD, AND PROGRAM**

(30) Priority: 11.08.2008 JP 2008207430
(71) Applicant: Sony Corporation, Tokyo 108-0075 (JP)
(72) Inventor: TAKIGUCHI Yasunari, Tokyo 108-0075 (JP); MIYASHITA Masatomo, Tokyo 108-0075 (JP)
(74) Representative: Jackson, Jonathan Andrew
(86) International application number: PCT/JP2009/063938
(87) International publication number: WO 2010/018780

(57) **Abstract**

Picture quality deterioration that occurs during channel transition is reduced in an apparatus having a plurality of tuners. A receiver apparatus includes a receiving unit 300 configured to select a signal of a desired channel from respective received signals split by a splitter unit that splits the received signal into at least two or more signals, and to obtain an intermediate frequency signal or a baseband signal. The receiver apparatus further includes a local oscillator unit 305 configured to generate a frequency signal necessary for the receiving unit 300 to generate the intermediate frequency signal or the baseband signal, and to supply the generated frequency signal to the receiving unit 300, and a PLL unit 310 configured to generate a frequency control voltage for controlling an oscillating frequency of the local oscillator unit 305. The receiver apparatus further includes a control unit 40 configured to perform a control of decelerating the speed of changing the frequency control voltage by the PLL unit 310 when the receiving unit 300 changes its reception channel and it is detected that the changed channel crosses a channel that is being selected by another receiving unit that receives the received signals split by the splitter unit.

## Description

### Technical Field

The present invention relates to a receiver apparatus, a receiving method, and a program that can be applied suitably to, for example, a television receiver having a tuner.

### Background Art

In recent years, television receivers and, recording and reproducing apparatuses, such as DVD (Digital Versatile Disc) recorders, and HDD (Hard Disk Drive) recorders, which incorporate two or more tuners, have become more widespread. Moreover, in many cases, an RF (Radio Frequency) signal received by an antenna is split by a splitter, and the split signals are supplied to a plurality of apparatuses that incorporate a tuner.

Employing such a configuration makes it possible, for example, to receive a program that is being broadcast by a certain broadcast station (hereinafter also referred to as a "channel") by one of the tuners while at the same time receiving a program that is being broadcast on another channel by another tuner.

It is also possible to record a program received by one of the tuners into a HDD or the like while displaying video images of another program received by another tuner on a display screen. When using a display device in which the display screen area can be divided into a plurality of areas, it is also possible to display video images of different programs received by a plurality of tuners on the respective divided display areas.

In addition, while receiving a program that is broadcast on a certain channel by one of the tuners, it is possible to receive an EPG (Electronic Program Guide) using another tuner.

A plurality of tuners are controlled independently of each other by a control unit configured to have a microcomputer or the like. Thereby, they are allowed to select different channels from each other.

For example, Patent Document 1 discloses a television receiver having two tuners, namely, a main tuner and a sub tuner.
Patent Document 1 : JP-A-2000-350108

When a switching operation for channel selection is performed by one of the tuners in such an apparatus that incorporates a plurality of tuners or in a plurality of apparatuses that receive split RF signals, that operation may sometimes have an adverse effect on another tuner. This adverse effect may cause a phenomenon in which the video images that are being received by another tuner are polluted by noise.

For example, it is assumed that in a television receiver that incorporates two tuners, one of the tuners is tuned in a specific channel of digital terrestrial television broadcasting while the other tuner switches channels of digital terrestrial television broadcasting.

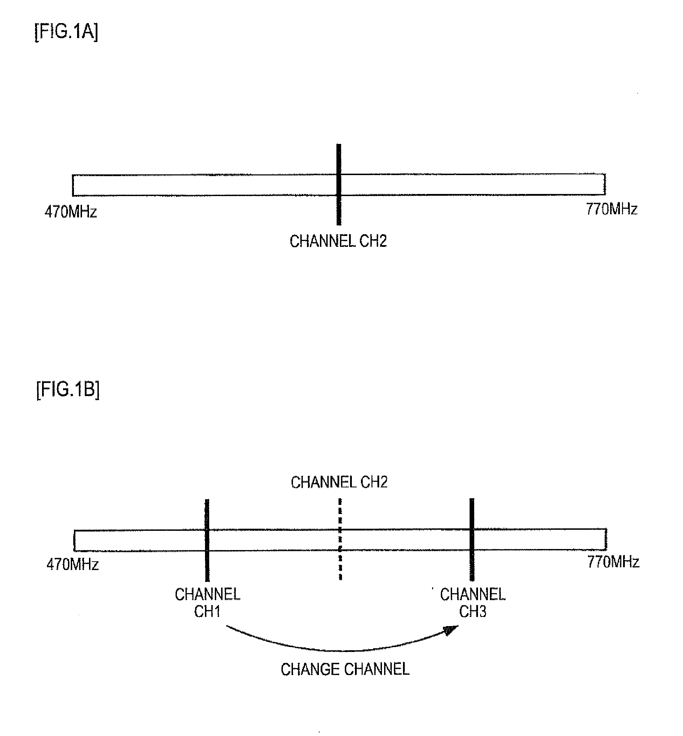

Fig. 1 shows channel selection states of each of the tuners in such a television receiver. Fig. 1(a) shows a channel selection state of a tuner (first tuner) that is tuned in a channel CH2, while Fig. 1(b) shows a channel selection state of another tuner (second tuner) that performs channel switching. In Figs. 1(a) and 1(b), the horizontal axis represents channel frequency.

Fig. 1(a) shows that the channel CH2 is selected in the first tuner. Under such a condition, the second channel switches the channel from a channel CH1 having a lower frequency than the channel CH2 to a channel CH3 having a higher frequency than the channel CH2, as shown in Fig. 1(b).

In this case, in the second tuner, the value of a frequency control voltage for switching channels changes from the voltage value for selecting the channel CH1 to the voltage value for selecting the channel CH3, based on the control a control unit (not shown). This change in voltage value takes place gradually, taking a certain length of time. As a result, there is a moment at which the voltage value becomes the same voltage as the voltage value for selecting the channel CH2. Thus, a problem arises when the frequency control voltages in the two tuners become the same value.

When the value of the frequency control voltage in the second tuner becomes the same as the voltage value for selecting the channel CH2, the impedance condition in the first tuner and the impedance condition in the second tuner become equal to each other instantaneously. Thereby, the input impedance in the first tuner changes abruptly, and the input level of the RF signal that is input into the first tuner fluctuates temporarily. The fluctuation occurs only in a short time at which the value of the frequency control voltage crosses the voltage value for selecting the channel CH2 in the second tuner, and thereafter, the level of the RF signal that is input to the first tuner returns to the previous level.

A tuner is provided with an AGC (Automatic Gain Control) circuit for keeping the output level of a signal being constant. However, when the input level of the RF signal abruptly changes in such a way, the AGC circuit in the first tuner cannot follow the change. In other words, it can no longer perform an appropriate control. This leads to the problem of causing picture quality deterioration, such as producing lines in the video images that are output on a display screen and generating block noise.

Thus, it is desirable that picture quality deterioration that occurs during channel transition is reduced in an apparatus having a plurality of tuners or in respective apparatuses that receive split RF signals.

### Summary of the Invention

A receiver apparatus according to an embodiment of the invention includes a receiving unit configured to select a signal of a desired channel from respective received signals split by a splitter unit that splits the received signal into at least two or more signals and to obtain an intermediate frequency signal or a baseband signal. The receiver apparatus further includes a local oscillator unit configured to generate a frequency signal necessary for generating the intermediate frequency signal or the baseband signal, and to supply the generated frequency signal to the receiving unit, and a PLL unit configured to generate a frequency control voltage for controlling an oscillating frequency of the local oscillator unit using the frequency signal output from the local oscillator unit as a feedback signal.
Moreover, when the receiving unit changes its reception channel and it is detected that the changed channel crosses a channel that is being selected by another receiving unit that receives the received signals split by the splitter unit, a control of decelerating the speed of changing the frequency control voltage is performed using the PLL unit.

With such a configuration, since the process of generating the frequency control voltage in the frequency control voltage generating units is also performed slowly, a transient response of the local oscillator unit at the time of channel selection is also slowed down. As a result, even when crossing the channel being selected by another tuner at the time of channel transition, fluctuation of the input impedance that occurs in the other tuner becomes gentle, and fluctuation of the level of the signal that is input to the other tuner also becomes gentle.

According to the embodiment of the invention, even when the switched channels cross the channel being selected by another tuner at the time of channel transition, the fluctuation of the level of the input signal originating from the fluctuation of the input impedance that occurs in the other tuner becomes gentle. Thereby, appropriate control is performed also in the case where automatic gain control is carried out by an AGC circuit, and picture quality deterioration in the output images is prevented.

### Brief Description of the Drawings

[Fig. 1] It is an example of the channel selection state in the first channel and the second channel according to the related art.
[Fig. 2] It is a block diagram showing an example of the configuration of a first tuner and a second tuner according to a first embodiment of the invention.
[Fig. 3] It is a block diagram showing an example of the internal configuration of a second tuner according to the first embodiment of the invention.
[Fig. 4] It is an example of the relationship between a change of frequency control voltage and a change of RF input signal level according to the first embodiment of the invention, wherein (a) shows an example in the case where the current supplied from a charge pump unit is large, and (b) shows an example in the case where the current supplied from the charge pump unit is small.
[Fig. 5] It is a flowchart showing an example of a process in the control unit according to the first embodiment of the invention.
[Fig. 6] It is a block diagram showing an example of the configuration of a first tuner and a second tuner according to a second embodiment of the invention.
[Fig. 7] It is a flowchart showing an example of a process in the control unit according to the second embodiment of the invention.
[Fig. 8] It is an application example (1) of the receiver apparatus according to the second embodiment of the invention.
[Fig. 9] It is an application example (2) of the receiver apparatus according to the second embodiment of the invention.

### Mode for Carrying Out the Invention

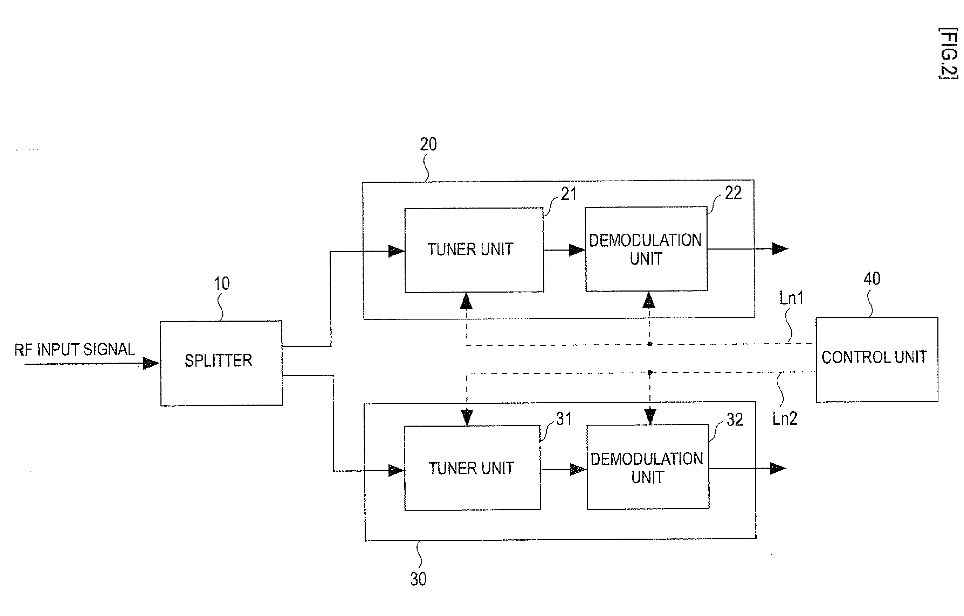

Hereinbelow, embodiments of the invention will be described with reference to Figs. 2 to 9. These embodiments will be described in the following order:
1. First Embodiment (configuration example of receiver apparatus incorporating a plurality of tuners)
2. Second Embodiment (configuration example of a case where signals split by a splitter are received by a plurality of receiver apparatuses incorporating a tuner)

### <First Embodiment>

Hereinbelow, a first embodiment of the invention will be described with reference to Figs. 2 to 5. In the first embodiment, the receiver apparatus of the invention is applied to a television receiver that incorporates two tuners.

### [Example of Overall Configuration of the Apparatus]

Fig. 2 shows an example of the configuration of a receiving portion of a television receiver to which the receiver apparatus of this embodiment is applied. It should be noted that although this example shows a case in which an embodiment of the invention has been applied to a television receiver, an embodiment of the invention may be applied to recording and reproducing apparatus including video tape recorders, HDD recorders, DVD recorders, and Blu-ray (registered trademark) recorders, and other apparatus including personal computers as long as the apparatus has a tuner.

As shown in Fig. 2, the television receiver according to this embodiment has a splitter 10 for splitting RF input signal into two, a first tuner 20, a second tuner 30, and a control unit 40 for controlling the first tuner 20 and the second tuner 30. The first tuner 20 has a tuner unit 21 and a demodulation unit 22. The second tuner 30 has a tuner unit 31 and a demodulation unit 32. The tuner unit 21 and the demodulation unit 22 in the first tuner are connected to the control unit 40 via a control line Ln1. The tuner unit 31 and the demodulation unit 32 in the second tuner 30 are connected to the control unit 40 via a control line Ln2. Thus, the tuner unit 21 and the demodulation unit 22, which are in the first tuner 20, and the tuner unit 31 and the demodulation unit 32, which are in the second tuner 30, are controlled by the same control unit 40.

Each of the tuner unit 21 and the tuner unit 31 selects a radio wave of a desired channel among the RF input signals that are split by the splitter 10, and converts and amplifies the frequency of the selected signal into an intermediate frequency signal. Each of the demodulation unit 22 and the demodulation unit 32 extracts a video signal and an audio signal from an intermediate frequency signal (hereinafter also referred to as an IF signal) that is output from the tuner unit 21 and the tuner unit 31, and outputs the signals to a display unit or a speaker, which is not shown in the drawings.

The control unit 40 includes a microcomputer or the like. It outputs information necessary for channel switching to each of the tuners when it is instructed to switch a channel from a user via a remote control device or the like or when it switches a channel at a recording time specified by the user. Examples of the information necessary for channel switching include a frequency division ratio in a programmable frequency divider, which will be described later, and an AGC level in a later-described AGC circuit, which also will be described later.

Moreover, the control unit 40 also acquires information (channel-selecting frequency) on a channel that is being selected by the first and second tuners 20 and 30 and records the acquired information in a table (not shown) or the like at a predetermined timing such as a timing (idle period) at which the processing load is low, for example. Moreover, the control unit 40 refers to the value in the table when the first tuner 20 or the second tuner 30 starts channel selection and determines whether or not the channel selected by one of the tuners crosses a channel that is being selected by the other tuner. Moreover, when it is determined that the channel selected by one of the tuners crosses the channel that is being selected by the other tuner, the control unit 40 performs the following control.

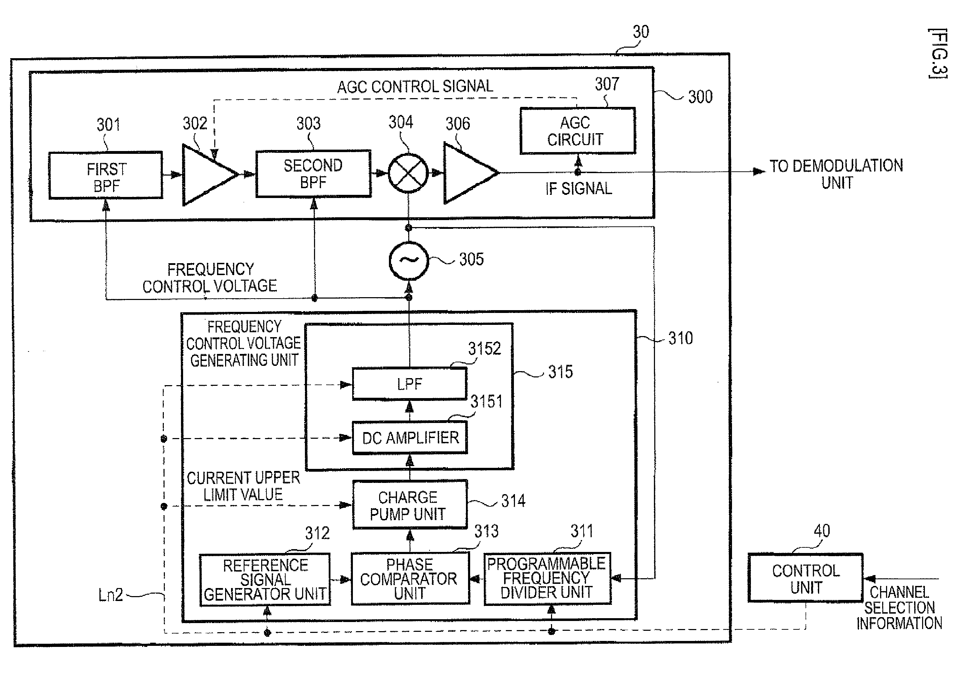

Fig. 3 shows an example of the internal configuration of the second tuner 30. This embodiment takes a case where the second tuner 30 performs channel switching such as to pass across the channel that is being selected by the first tuner 20 as an example. Therefore, the configuration of the second tuner 30 will be described in this embodiment. It should be noted, however, that the first tuner 20 also has the same configuration as that of the second tuner 30.

The second tuner 30 includes a receiver circuit (receiving unit) 300 and a PLL (Phase Locked Loop) circuit 310. The receiver circuit 300 is configured to have a first band-pass filter (hereinafter referred to as "BPF") 301, a low-noise amplifier 302, a second BPF 303, a mixer 304, a local oscillator 305, an intermediate-frequency amplifier 306, and an AGC circuit 307 as an automatic gain control unit.

The first BPF 301 is a tuning circuit having a coil, a variable capacitor, and the like, which are not shown in the drawings. It selects a desired reception frequency by changing the capacitance of the variable capacitor. It also eliminates unnecessary signal that causes disturbance. The low-noise amplifier 302 amplifies the high-frequency voltage that has passed through the first BPF 301, and outputs it to the second BPF 303. The second BPF 303 is a filter for attenuating a frequency component that is other than the desired frequency and causes disturbance (image frequency). The signal that has passed through the second BPF 303 is input into the mixer 304.

The mixer 304 mixes a signal of a desired frequency that passes through the second BPF 303 and a local oscillation signal that is output from the local oscillator 305 to convert the signals into IF signal. The local oscillator 305 generates a frequency signal for converting the RF signal into IF signal based on the frequency control voltage that is output from the PLL circuit 310, and outputs the resulting signal to the mixer 304.

The intermediate-frequency amplifier 306 amplifies the IF signal converted by the mixer 304. It also performs optimization of the signal level, and outputs the adjusted IF signal to the demodulation unit 32 (see Fig. 2). The AGC circuit 307 extracts the IF signal amplified by the intermediate-frequency amplifier 306 to generate an AGC control signal for adjusting the gain in the low-noise amplifier 302, and it supplies the generated AGC control signal to the low-noise amplifier 302.

The PLL circuit 310 generates a frequency control voltage for controlling the oscillating frequency of the local oscillator 305, using the local oscillation signal that is output from the local oscillator 305 as a feedback signal. The PLL circuit 310 has a programmable frequency divider unit 311, a reference signal generator unit 312, a phase comparator unit 313, a charge pump unit 314, and a frequency control voltage generating unit 315.

The programmable frequency divider unit 311 optimizes the level of the signal that is fed back from the local oscillator 305 (hereinafter also referred to as "feedback signal"), and it also frequency-divides the feedback signal to have a predetermined frequency based on the frequency division ratio supplied from the control unit 40. Then, it outputs the adjusted signal to the phase comparator unit 313.

The reference signal generator unit 312 generates a reference signal that is set to be a predetermined frequency based on the controlling by the control unit 40, and supplies the generated reference signal to the phase comparator unit 313. The phase comparator unit 313 compares the phase of the reference signal supplied from the reference signal generator unit 312 and the phase of the signal that is output from the programmable frequency divider unit 311. It generates a signal indicating the current level and polarity according to the phase difference, and outputs the signal to the charge pump unit 314.

The charge pump unit 314 serves the role of a power source. It generates a current/voltage having a desired level and a polarity based on the content of the signal that is output from the phase comparator unit 313 and the control content from the control unit 40, and outputs the current/voltage to the frequency control voltage generating unit 315. The upper limit value of the current generated by the charge pump unit 314 is set to be a level instructed by the control unit 40. The level of the upper limit value of the current (hereinafter also referred to as a "current upper limit value" ) may be set, for example, into 5 steps.

The frequency control voltage generating unit 315 generates a frequency control voltage having a magnitude corresponding to the level of the current/voltage that is input from the charge pump unit 314. The frequency control voltage is used for controlling the local oscillator 305, the first BPF 301, and the second BPF 303.

The frequency control voltage generating unit 315 includes a DC amplifier 3151 and a low-pass filter (hereinafter referred to as "LPF") 3152. The DC amplifier 3151 subjects a current input from the charge pump unit 314 to DC amplification and outputs the amplified current to the LPF 3152. The LPF 3152 integrates the current amplified by the DC amplifier 3151 to generate a DC voltage and supplies the generated DC voltage to the local oscillator 305.

In the local oscillator 305, the frequency of the local oscillation signal is determined by the frequency control voltage. Moreover, the speed of the transient response of the local oscillator 305 at the time of channel selection is determined by the speed of the frequency control voltage generation operation. In the first BPF 301 and the second BPF 303, the filter characteristics thereof are determined by the frequency control voltage.

The speed of the frequency control voltage generation operation in the frequency control voltage generating unit 315, namely the speed of the transient response of the local oscillator 305 at the time of channel selection is changed by changing the following settings.
(1) The loop gain in the PLL circuit 310; and
(2) The magnitude of the cut-off frequency of a loop filter of the PLL circuit 310.

The magnitude of the loop gain in the PLL circuit 310 mentioned in (1) can be changed by adjusting the magnitude of the gain of the DC amplifier 3151 or the magnitude of the current of the charge pump unit 314.

That is, when the gain of the DC amplifier 3151 is increased, since the loop gain increases, the frequency control voltage generation operation is accelerated. On the other hand, when the gain of the DC amplifier 3151 is decreased, since the loop gain decreases, the speed of the frequency control voltage generation operation is decelerated.

Moreover, even when the current supplied by the charge pump unit 314 is increased, since the loop gain increases, the speed of the frequency control voltage generation operation is accelerated. When the current supplied by the charge pump unit 314 is decreased, since the loop gain decreases, the speed of the frequency control voltage generation operation is decelerated.

The magnitude of the cut-off frequency of the loop filter of the PLL circuit 310 mentioned in (2) can be controlled by increasing or decreasing the cut-off frequency of the DC amplifier 3151.

That is, when the cut-off frequency of the DC amplifier 3151 is increased, the speed of the frequency control voltage generation operation is accelerated. When the cut-off frequency of the DC amplifier 3151 is decreased, the speed of the frequency control voltage generation operation is decelerated.

In this embodiment, when a certain tuner performs switching (selection) of a channel, and the switched channel crosses a channel that is being selected by another tuner at the time of the channel selection, a process of decelerating the frequency control voltage generation operation is performed. In this way, since the transient response of the local oscillator 305 is temporarily slowed down, the control in the AGC circuit is performed so as to follow a change in the level of the input RF signal.

In this embodiment, a case where the speed of the transient response of the local oscillator 305 at the time of channel selection is changed by controlling the magnitude of the current supplied by the charge pump unit 314 will be described as an example.

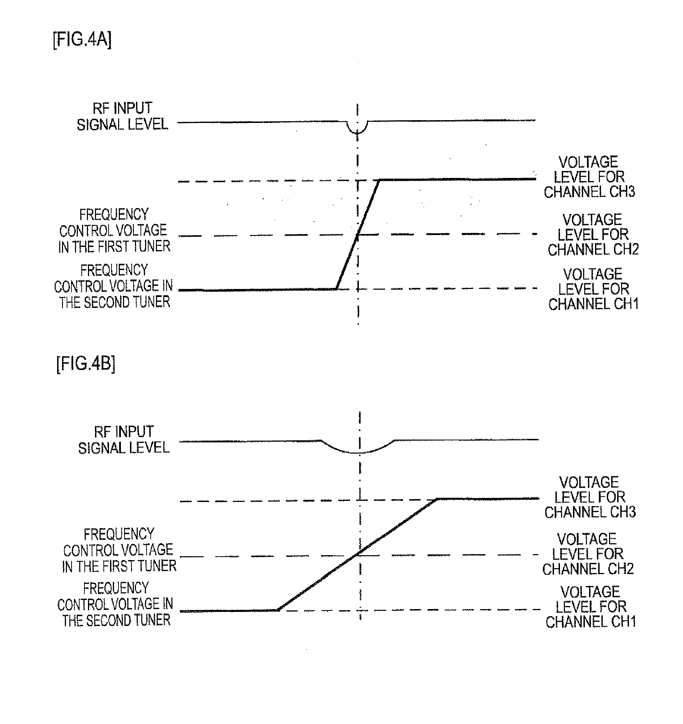

Fig. 4(a) shows an example of the transition of the voltage level of the frequency control voltage of the frequency control voltage generating unit 315 at the time of channel switching in the case where the current supplied from the charge pump unit 314 to the frequency control voltage generating unit 315 is large. Fig. 4(b) shows an example of the transition of the voltage level of the frequency control voltage of the frequency control voltage generating unit 315 at the time of channel switching in the case where the current supplied from the charge pump unit 314 to the frequency control voltage generating unit 315 is small.

In Figs. 4(a) and 4(b), the horizontal axis represents time. Along the vertical axis, the top most graph indicates the level of the RF signal that is input to the first tuner 20, and the graphs lower than that represent the voltage level for selecting a channel CH3, the voltage level for selecting a channel CH2, and the voltage level for selecting a channel CH3, respectively. The transition of frequency control voltage generated by the frequency control voltage generating unit 315 of the second tuner 30 is shown by the bold.

Fig. 4(a) shows that the voltage level of the frequency control voltage at the frequency control voltage generating unit 315 of the second tuner 30 rapidly changes from the voltage level for selecting the channel CH1 to the voltage level for selecting the channel CH3. In the example shown in Fig. 4(a), the current supplied from the charge pump unit 314 to the frequency control voltage generating unit 315 is large. Therefore, the operation of the frequency control voltage generating unit 315 is performed at high speed, and the voltage level of the frequency control voltage changes rapidly.

In addition, it is demonstrated that the level of the RF input signal fluctuates when the voltage level of the frequency control voltage at the frequency control voltage generating unit 315 of the second tuner 30 crosses the voltage level associated with the channel CH2 that is being selected by the first tuner 20. First, the level of the frequency control voltage supplied to the first BPF 301 of the second tuner 30 becomes the same as the voltage level for selecting the channel CH2 that is being selected by the first tuner 20, and thereby, the impedance conditions of the first tuner 20 and the second tuner 30 substantially become equal to each other temporarily. As a consequence, the input impedance of the first tuner 20 abruptly changes, and therefore, the signal level of the RF signal that is input to the first tuner 20 also fluctuates instantaneously.

In the example shown in Fig. 4(a), transition of the voltage level of the frequency control voltage in the second tuner 30 is performed at a high speed. Therefore, fluctuation of the signal level of the RF signal that is input to the first tuner 20 also occurs in a short period of time. In such a case where the level of the RF input signal fluctuates in a short period of time, the controlling of the first tuner 20 by the AGC circuit (not shown) cannot keep pace with the fluctuation, as described above. Therefore, the picture quality in the video images that are output to the display device or the like deteriorates temporarily.

On the other hand, when the voltage level of the frequency control voltage of the frequency control voltage generating unit 315 in the second tuner 30 is changed taking a comparatively long period of time, as shown in Fig. 4(b), fluctuation of the level of the RF input signal to the first tuner 20 becomes gentle. When the fluctuation of the RF input signal is gentle, the AGC circuit of the first tuner 20 can follow the change accordingly. Therefore, the image quality of the video images that are output to a display screen becomes free of noise.

For this reason, this embodiment performs a process of setting the current upper limit value of the charge pump unit 314 to be the lowest value (level) in case of switching channels, and detecting to cross channel being selected by another tuner. It should be noted that this example shows an example in which the current upper limit value of the charge pump unit 314 is set to be the lowest level that can be set, but this is not to be construed as limiting. For example, in a case where the current upper limit value of the charge pump unit 314 can be set in 5 steps, the current upper limit value may be changed to be the second lowest level, for example.

### [Operation Example of the Apparatus]

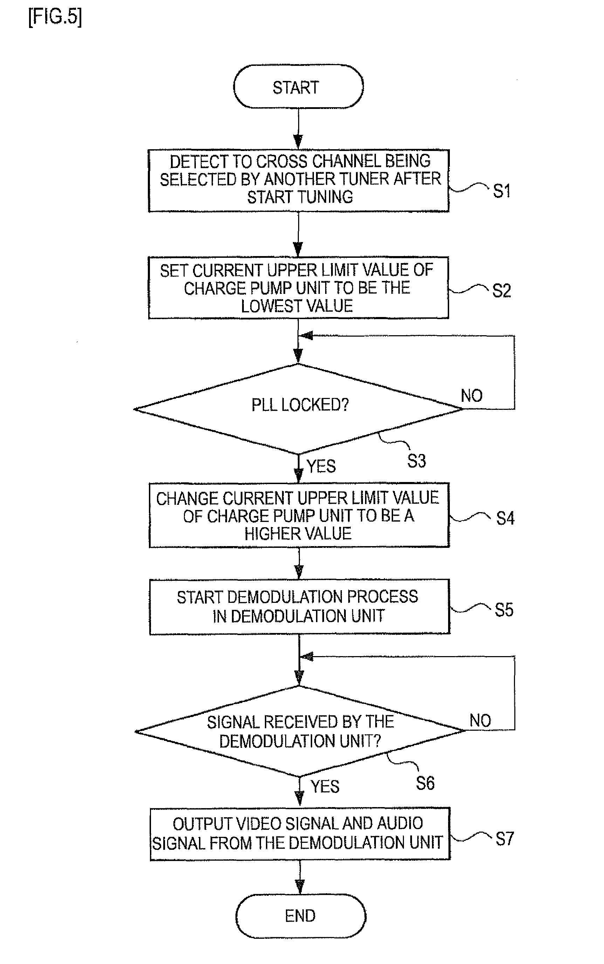

Hereinbelow, an example of the process in the control unit 40 of the second tuner 30 will be described with reference to the flowchart of Fig. 5. It should be noted that this embodiment takes a case where channel switching is performed by the second tuner 30 as an example, and therefore, the following control process is performed in the second tuner 30. However, there may be an opposite case. Specifically, in a case where channel switching is performed by the first tuner 20, the following process is performed in the first tuner 20.

First, channel selection is started in the second tuner 30 and to cross channel being selected by another tuner is detected (step S1). Then, the current upper limit value of the charge pump unit 314 is set to be the lowest level that can be set by the control unit 40 (step S2). Then, it is determined whether or not the PLL circuit 310 is locked (step S3). Specifically, it is determined whether or not the frequency of the reference signal that is input into the phase comparator unit 313 (see Fig. 3) matches the frequency of the feedback signal that is frequency-divided. The determination in step S3 is repeated until the time at which the PLL circuit 310 is locked, i.e., until the time at which channel switching is completed. If it is confirmed that the PLL circuit 310 is locked, the current upper limit value of the charge pump unit 314 is returned to a high level at which the current upper limit value has been before the setting change, or another desired high level, based on the control by the control unit 40 (step S4).

Along with that, a demodulation process in the demodulation unit 32 is started (step S5). Next, the demodulation unit 32 determines whether or not the reception of video signal and audio signal was received (step S6). The determination of step S6 is repeated until the reception is completed. At the point at which the reception is completed, the video signal and the audio signal are output from the demodulation unit 32 (step S7).

### [Advantageous Effects obtained by First Embodiment]

According to the foregoing embodiment, when channel switching is performed in the second tuner 30, and the switched channel crosses a channel that is selected by the other tuner, the upper limit value of the current generated by the charge pump unit 314 is set to be the lowest level to restrict the amount of the current supplied to the frequency control voltage generating unit 315. In this way, since the level of the frequency control voltage generated by the frequency control voltage generating unit 315 is changed gently over a period of time, the transient response of the local oscillator 305 at the time of channel selection is also slowed down. Accordingly, the fluctuation of the input impedance in the first tuner 20 is made no longer abrupt. As a result, since the level of the RF signal input to the first tuner 20 is also changed gently, the control in the AGC circuit is performed so as to follow the change in the level of the input RF signal. That is, quality deterioration of the pictures that are output to the display unit or the like can be suppressed.

In this case, the current upper limit value in the charge pump unit 314 is returned to the original value before changed or another desired high value at the timing at which the channel selection is completed and the PLL circuit 310 is locked. Therefore, the reception sensitivity of the second tuner 30 is prevented from degrading.

Moreover, the current upper limit value in the charge pump unit 314 is changed to the original value or another desired high value that is necessary for stable picture rendering after the channel transition in the second tuner 30 is completed. Therefore, adverse effects on the input RF signal to the first tuner 20 can be prevented.

Furthermore, the above-described processes of changing the setting or resetting of the current upper limit value of the charge pump unit 314 are performed only by the control unit 40. Therefore, the processes can be introduced easily without changing the existing circuit configuration.

### [Other Examples of First Embodiment]

In the first embodiment described above, although an example in which the setting of the upper limit value of the current generated by the charge pump unit 314 is changed only when the channel is switched, and the switched channel crosses a channel that is being selected by another tuner has been described, the invention is not limited to this example. For example, such a control may always be performed when the channel is switched without determining whether or not the switched channel crosses a channel that is being selected by the other tuner.

Moreover, in the first embodiment described above, although an example in which the transient response of the local oscillator 305 at the time of channel selection is slowed down by changing the upper limit value of the current generated by the charge pump unit 314 has been described, the invention is not limited to this example. For example, as described above, the transient response of the local oscillator 305 at the time of channel selection may be slowed down by decreasing the gain of the DC amplifier 3151 or decreasing the cut-off frequency of the LPF 3152.

In this case, the value of the gain of the DC amplifier 3151 which is temporarily decreased is set to a value which does not break the loop of the PLL circuit 310 and which does not exceed an initial setting value. Similarly, the value of the cut-off frequency of the LPF 3152 which is temporarily decreased is set to a value which does not generate a bound and which does not exceed an initial setting value.

Moreover, in the first embodiment described above, although an example in which a determination as to whether or not a channel selected by a certain tuner crosses a channel that is being selected by the other tuner when the certain tuner selects the channel is made by the control unit 40 reading the value recorded in the table has been described, the invention is not limited to this example. For example, whenever a certain tuner starts channel selection, the certain tuner may make inquiries as to the state of channel selection in the other tuners and make the determination based on the results of the inquiries.

In the foregoing embodiments, a receiver apparatus that incorporates two tuners is taken as an example. However, the embodiments may be applied to an apparatus that incorporates three or more tuners.

The above-described embodiment uses, as the tuner, a tuner in which the intermediate frequency signal is obtained by mixing the channel-selecting frequency signal with the received signal, but it is possible to use a tuner in which the baseband signal is obtained directly by mixing the channel-selecting frequency signal with the received signal.

### [Second Embodiment]

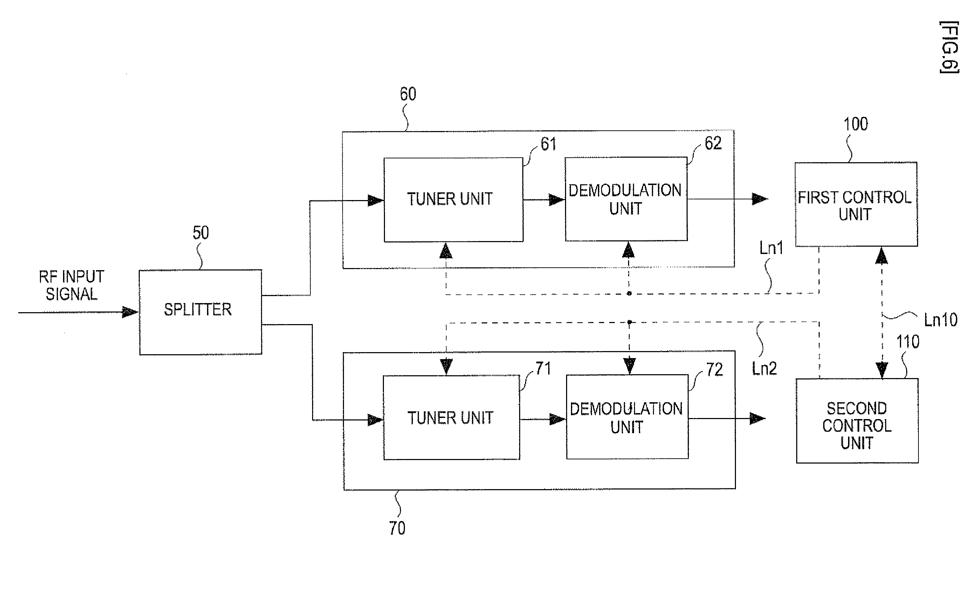

Next, a second embodiment of the invention will be described with reference to Figs. 6 to 9. In the second embodiment, the receiver apparatus of the invention is applied to a receiver apparatus in which RF signals split by a splitter are received by a plurality of receiver apparatuses that incorporate a tuner.

### [Example of Overall System Configuration]

The block diagram shown in Fig. 6 illustrates an example of a functional configuration of a system configured in such a form. The system shown in Fig. 6 includes a splitter 50 for splitting an RF input signal, a first tuner 60, and a first control unit 100 for controlling the first tuner 60. The system also includes a second tuner 70 and a second control unit 110 for controlling the second tuner 70.

The first tuner 60 includes a tuner unit 61 and a demodulation unit 62, and the second tuner 70 includes a tuner unit 71 and a demodulation unit 72. Moreover, the tuner unit 61 and the demodulation unit 62 of the first tuner are connected to the first control unit 100 through a control line Ln1. Moreover, the tuner unit 71 and the demodulation unit 72 of the second tuner 70 are connected to the second control unit 110 through a control line Ln2.

The first control unit 100 and the second control unit 110 are connected to a control line Ln10 which is formed, for example, by a HDMI (High Definition Multimedia Interface) cable, or the like, and the respective control units can share information about a channel that is being selected through the control line Ln10.

It is assumed that the first tuner 60 and the second tuner 70 have the same configuration as the first tuner 20 and the second tuner 30 shown in Fig. 2. That is, each of the first and second tuners 60 and 70 includes the respective blocks shown in Fig. 3.

### [Operation Example of Apparatus]

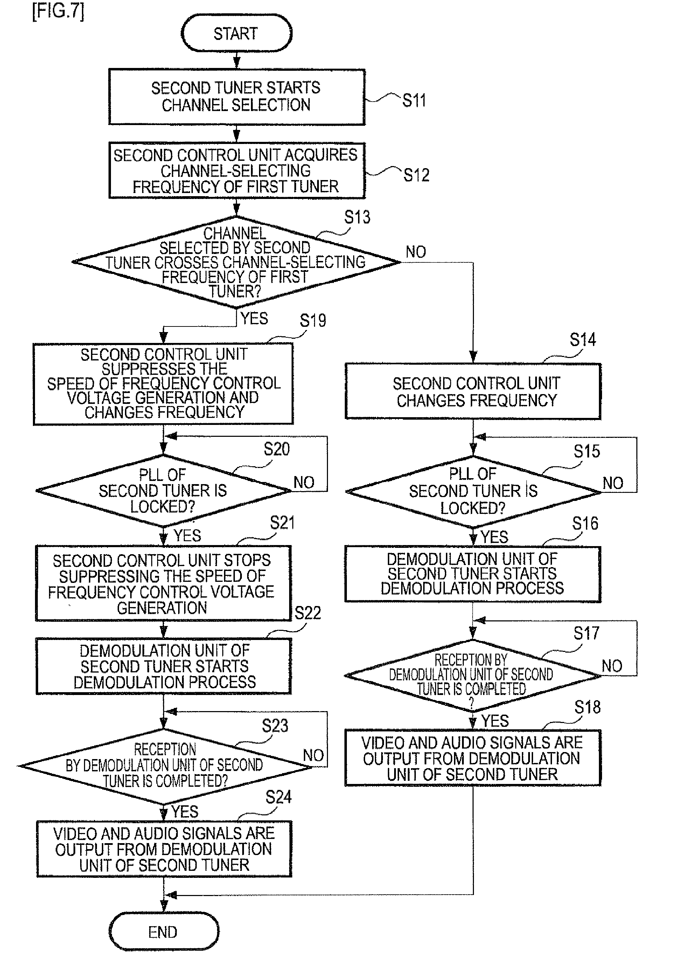

Next, an example of the control performed in a receiver apparatus on the side where channel selection is performed will be described with reference to the flowchart of Fig. 7. The operation shown in Fig. 7 illustrates an example where the second tuner 70 performs channel switching.

First, when channel selection is started in the second tuner 70 (step S11), the second control unit 110 controlling the second tuner 70 acquires a channel-selecting frequency of the first tuner 60 (step S12). Subsequently, the second control unit 110 determines whether or not the channel selected by the second tuner 70 crosses the channel-selecting frequency that is being selected by the first tuner 60 (step S13).

When the channel selected by the second tuner 70 does not cross the channel-selecting frequency that is being selected by the first tuner 60, the second control unit 110 performs a control of changing the frequency of the local oscillation signal generated by the local oscillator 305 (see Fig. 3) (step S14).

Subsequently, the second control unit 110 determines whether the PLL circuit 310 (see Fig. 3) in the second tuner 70 is locked (step S15), and when it is determined that the PLL circuit 310 is not locked, the determination of step S15 is continued.

When it is determined that the PLL circuit 310 in the second tuner 70 is locked, the demodulation process by the demodulation unit 72 in the second tuner 70 is started (step S16). Subsequently, it is determined whether or not the reception of the video and audio signals is completed by the demodulation unit 72 (step S17). The determination of step S17 is repeated until the reception is completed. At the time point at which the reception is completed, the video signal and the audio signal are output from the demodulation unit 72 (step S18).

On the other hand, when it is determined in step S13 that the channel selected by the second tuner 70 crosses the channel-selecting frequency that is being selected by the first tuner 60, the second control unit 110 performs a control for suppressing (decelerating) the speed of the frequency control voltage generation operation by the frequency control voltage generating unit 315 and applies settings so as to change the channel-selecting frequency (step S19).

As for the control of decelerating the speed of the frequency control voltage generation operation by the frequency control voltage generating unit 315, a control of decreasing the loop gain of the PLL circuit 310 or a control of decreasing the cut-off frequency of the LPF 3152 (see Fig. 3) is performed as mentioned in the first embodiment.

Subsequently, the second control unit 110 determines whether or not the PLL circuit 310 in the second tuner 70 is locked (step S20), and when it is determined that the PLL circuit 310 is not locked, the determination of step S20 is continued.

When it is determined that the PLL circuit 310 in the second tuner 70 is locked, the second control unit 110 stops the control of decelerating the speed of the frequency control voltage generation operation (step S21).

Moreover, the demodulation process by the demodulation unit 72 in the second tuner 70 is started (step S22). Subsequently, it is determined whether or not the reception of the video and audio signals is completed by the demodulation unit 72 (step S23). The determination of step S23 is repeated until the reception is completed. At the time point at which the reception is completed, the video signal and the audio signal are output from the demodulation unit 72 (step S24).

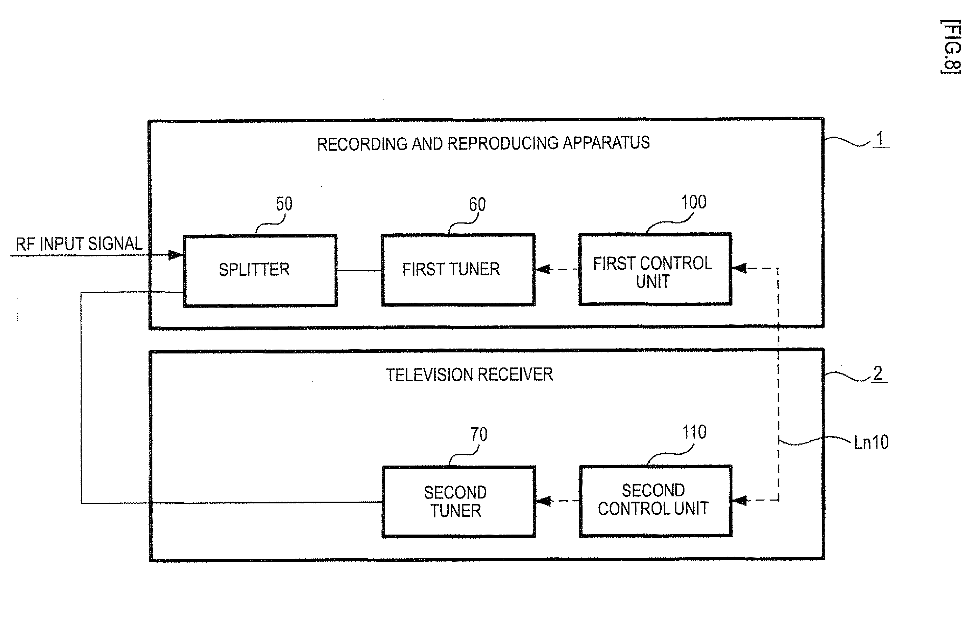

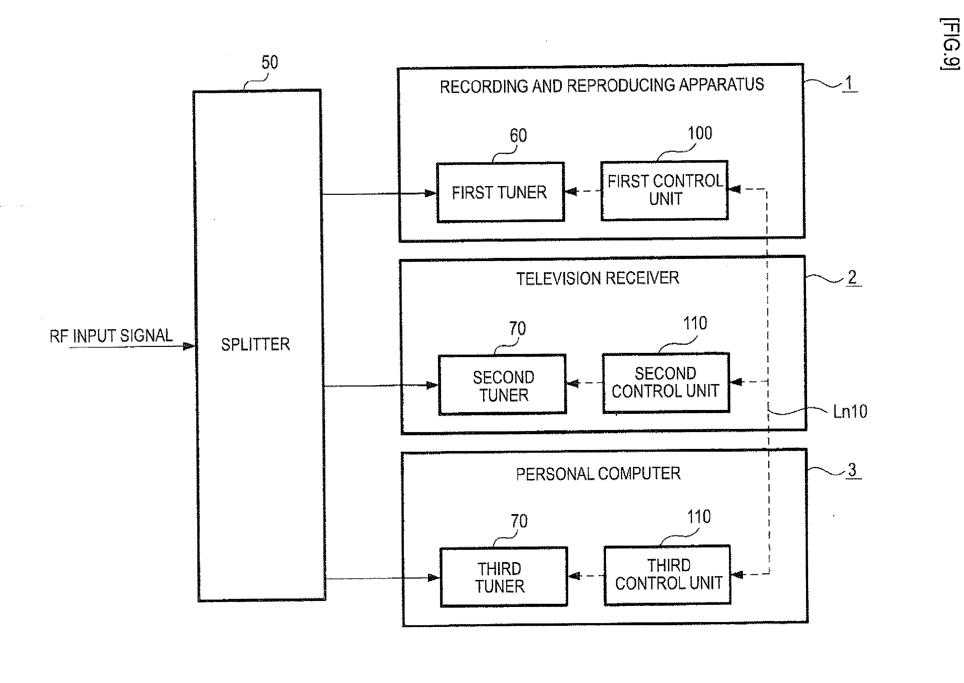

Next, a configuration example of a specific system to which the second embodiment is applied will be described with reference to Figs. 8 and 9.

Fig. 8 shows a configuration in which an RF input signal obtained by an antenna (not shown) is received by a recording and reproducing apparatus 1 having the first tuner 60 and a television receiver 2 having the second tuner 70. As the recording and reproducing apparatus 1, an apparatus such as a video tape recorder, an HDD recorder, a DVD recorder, or a Blu-ray (registered trademark) recorder is used, for example.

In the configuration shown in Fig. 8, the splitter 50 in the recording and reproducing apparatus 1 distributes the RF input signal to the first tuner 60 in the recording and reproducing apparatus 1 and the second tuner 70 in the television receiver.

Although this example shows a configuration in which the RF input signal is distributed to the two apparatuses of the recording and reproducing apparatus 1 and the television receiver 2, the invention is not limited to this configuration. For example, the invention may be applied to a configuration in which a plurality of apparatuses each including a splitter and a tuner are connected to the recording and reproducing apparatus 1 shown in Fig. 8.

The first control unit 100 for controlling the first tuner 60 is provided in the recording and reproducing apparatus 1 shown in Fig. 8, and the second control unit 110 for controlling the second tuner 70 is provided in the television receiver 2. Moreover, the first control unit 100 and the second control unit 110 are connected via the control line Ln10.

A table (not shown) is stored in the first control unit 100 (or the second control unit 110), and information on the channel-selecting frequency being selected by the first tuner 60 and information on the channel-selecting frequency being selected by the second tuner 70 are stored in the table. Moreover, when switching (selection) of a channel is performed, the determination as to whether or not the selected channel crosses the channel-selecting frequency being selected by the other tuner is made by the first control unit 100 or the second control unit 110 referring to the value stored in the table.

It is assumed that the first tuner 60 and the second tuner 70 have the same internal configuration as that shown in Fig. 3. It is also assumed that the process performed by the control unit on the side where the channel selection is performed is the same as the process shown in Fig. 7. That is, when a certain tuner switches its channel, and the switched channel crosses a channel that is being selected by the other tuner, a control of decelerating the speed of the frequency control voltage generation operation is performed.

As mentioned in the first embodiment, the invention may be applied to a configuration in which the table is not provided in the first control unit 100 (or the second control unit 110), and the information on the channel-selecting frequency of the other tuner is acquired through communication on an as-needed basis.

Fig. 9 shows a configuration in which an RF input signal obtained by an antenna (not shown) is received by the recording and reproducing apparatus 1 having the first tuner 60, the television receiver 2 having the second tuner 70, and a personal computer 3 having a third tuner 80.

In the configuration shown in Fig. 9, an externally attached splitter 50' capable of splitting an input signal into a plurality of signals distributes the RF input signal.

Although the example shown in Fig. 9 shows a configuration in which the RF input signal is distributed to the three apparatuses of the recording and reproducing apparatus 1, the television receiver 2, and the personal computer 3, the invention is not limited to this configuration. That is, the invention may be applied to a configuration in which a plurality of apparatuses each including a tuner are connected to the splitter 50'.

The first control unit 100 for controlling the first tuner 60 is provided in the recording and reproducing apparatus 1 shown in Fig. 9, and the second control unit 110 for controlling the second tuner 70 is provided in the television receiver 2. Moreover, a third control unit 120 for controlling the third tuner 80 is also provided in the personal computer 3. Moreover, the first control unit 100, the second control unit 110, and the third control unit 120 are connected via the control line Ln10.

It is assumed that the first tuner 60, the second tuner 70, and the third tuner 80 have the same internal configuration as that shown in Fig. 3. It is also assumed that the process performed by the control unit on the side where the channel selection is performed is the same as the process shown in Fig. 7.

### [Advantageous Effects obtained by Second Embodiment]

According to the second embodiment described above, even in a configuration in which the RF input signals split by the splitter 50 (or the splitter 50') are distributed to a plurality of apparatuses each having a tuner, when a certain tuner switches its channel, and the switched channel crosses a channel that is being selected by the other tuner, a control of decelerating the speed of the frequency control voltage generation operation is performed. In this way, since the transient response of the local oscillator 305 (see Fig. 3) at the time of channel selection is also slowed down, the control in the AGC circuit is performed so as to follow the change in the level of the input RF signal. That is, quality deterioration of the pictures that are output to the display unit or the like can be suppressed.

Moreover, a series of processes in the above-described embodiment may be implemented by hardware, but it is also possible that the series of processes may be implemented by software. In the case where the series of processes are to be implemented by software, the series of processes may be implemented by installing a program that makes up the software in a control processing unit (such as a central control unit) that is incorporated in a dedicated hardware component.

In this description, the steps that describe a program that constitutes software may include not only the processes executed chronologically in the described order but also the processes not necessarily processed chronologically but executed individually or in parallel.

### [Description of Reference Numerals and Signs]

1: RECORDING AND REPRODUCING APPARATUS, 2: TELEVISION RECEIVER, 3: PERSONAL COMPUTER, 10: SPLITTER, 20: FIRST TUNER, 21: TUNER UNIT, 22: DEMODULATION UNIT, 30: SECOND TUNER, 31: TUNER UNIT, 32: DEMODULATION UNIT, 40: CONTROL UNIT, 50,50': SPLITTER, 60: FIRST TUNER, 61: TUNER UNIT, 62: DEMODULATION UNIT, 70: SECOND TUNER, 71: TUNER UNIT, 72: DEMODULATION UNIT, 80: THIRD TUNER, 100: FIRST CONTROL UNIT, 110: SECOND CONTROL UNIT, 120: THIRD CONTROL UNIT, 300: RECEIVING UNIT, 301: FIRST BPF, 302: LOW-NOISE AMPLIFIER, 303: SECOND BPF, 304: MIXER, 305: LOCAL OSCILLATOR, 306: INTERMEDIATE-FREQUENCY AMPLIFIER, 307: AGC CIRCUIT, 310: PLL CIRCUIT, 311: PROGRAMMABLE FREQUENCY DIVIDER UNIT, 312: REFERENCE SIGNAL GENERATOR UNIT, 313: PHASE COMPARATOR UNIT, 314: CHARGE PUMP UNIT, 315: FREQUENCY CONTROL VOLTAGE GENERATING UNIT, 3151: DC amplifier
AMPLIFIER, 3152: LOW-PASS FILTER, CH1, CH2, CH3: CHANNEL, Ln1, Ln2, Ln3, Ln10: CONTROL LINE

## Claims

1. A receiver apparatus comprising:
a receiving unit configured to select a signal of a desired channel from respective received signals split by a splitter unit that splits the received signal into at least two or more signals and to obtain an intermediate frequency signal or a baseband signal;
a local oscillator unit configured to generate a frequency signal necessary for the receiving unit to generate the intermediate frequency signal or the baseband signal, and to supply the generated frequency signal to the receiving unit;
a PLL unit configured to generate a frequency control voltage for controlling an oscillating frequency of the local oscillator unit using the frequency signal output from the local oscillator unit as a feedback signal; and
a control unit configured to perform a control of decelerating the speed of changing the frequency control voltage by the PLL unit when the receiving unit changes its reception channel and it is detected that the changed channel crosses a channel that is being selected by another receiving unit that receives the received signals split by the splitter unit.

2. The receiver apparatus according to claim 1, wherein the control by the control unit decelerating the speed of changing the control voltage is performed by a process of decreasing a loop gain of the PLL unit or a process of decreasing a cut-off frequency of a loop filter of the PLL unit.

3. The receiver apparatus according to claim 2,
wherein the receiving unit and the PLL unit are provided in plural numbers so as to correspond to the number of received signals split by the splitter unit, and
wherein the control unit controls the plurality of receiving units and the plurality of PLL units.

4. The receiver apparatus according to claim 2, wherein the control unit is connected to a receiver apparatus different from the receiver apparatus via a communication line, and acquires information on a channel that is being selected by the other receiver apparatus through communication performed via the communication line.

5. The receiver apparatus according to claim 2, wherein the PLL unit comprises:
a reference signal generator unit configured to generate a reference signal having a predetermined frequency based on the control of the control unit;
a phase comparator unit configured to compare the phase of the frequency signal generated by the local oscillator unit and the phase of the reference signal generated by the reference signal generator unit to obtain a phase difference, and to output the phase difference;
a charge pump unit configured to generate a current corresponding to the output from the phase comparator unit;
a DC amplifier configured to amplify the current generated by the charge pump unit; and
a low-pass filter configured to integrate the current amplified by the DC amplifier to obtain a DC current, and to supply the DC current to the local oscillator unit.

6. The receiver apparatus according to claim 5, wherein the process by the control unit decreasing the loop gain of the PLL unit is performed by decreasing an upper limit value of the current generated by the charge pump unit or decreasing the gain of the DC amplifier.

7. The receiver apparatus according to claim 5, wherein the process by the control unit decreasing the cut-off frequency of the loop filter of the PLL unit is performed by decreasing the cut-off frequency of the low-pass filter.

8. The receiver apparatus according to claim 2, wherein, at a time point when the channel change operation in the receiving unit is completed, the control unit stops the control of decelerating the speed of changing the control voltage.

9. The receiver apparatus according to claim 2, wherein the case where the changed channels cross the channel that is being selected by the other receiving unit is a case where the value of the frequency control voltage is equal to the value of a frequency control voltage supplied to the other receiving unit during transition of the channel.

10. The receiver apparatus according to claim 6, wherein, when changing the upper limit value of the current generated by the charge pump unit, the control unit sets the upper limit value of the current to a lowest value that can be set.

11. A reception method comprising the steps of:
selecting a signal of a desired channel from at least two or more received signals which are split from a received signal and obtaining an intermediate frequency signal or a baseband signal;
generating a frequency signal necessary for generating the intermediate frequency signal or the baseband signal;
generating a frequency control voltage for controlling an oscillation frequency using the frequency signal as a feedback signal; and
decelerating the speed of changing the frequency control voltage when the reception channel is changed, and it is detected that the changed channel crosses a channel that is being selected by another reception process for receiving the split received signals.

12. A program for causing a computer to execute the steps of:
selecting a signal of a desired channel from at least two or more received signals which are split from a received signal and obtaining an intermediate frequency signal or a baseband signal;
generating a frequency signal necessary for generating the intermediate frequency signal or the baseband signal;
generating a frequency control voltage for controlling an oscillation frequency using the frequency signal as a feedback signal; and
decelerating the speed of changing the frequency control voltage when the reception channel is changed, and it is detected that the changed channel crosses a channel that is being selected by another reception process for receiving the split received signals.
